# EUROPÄISCHE PATENTANMELDUNG

(11) **EP 4 345 480 A1**
(43) Veröffentlichungstag der Anmeldung: **03.04.2024**
(21) Anmeldenummer: 22198701.9
(22) Anmeldetag: 29.09.2022
(51) Int. Cl.: G01R 33/561

(54) **VERFAHREN ZUR ITERATIVEN REKONSTRUKTION VON BILDDATEN AUS MITTELS EINER MAGNETRESONANZANLAGE AUFGENOMMENEN MESSDATEN**

(71) Anmelder: Siemens Healthineers AG, 91301 Forchheim (DE)
(72) Erfinder: Nickel, Marcel Dominik, 91074 Herzogenaurach (DE); Zeller, Mario, 91054 Erlangen (DE)
(74) Vertreter: Siemens Healthineers Patent Attorneys

(57) **Zusammenfassung**

Ein erfindungsgemäßes Verfahren zur Rekonstruktion von Bilddaten aus mittels einer Magnetresonanzanlage (1) aufgenommenen Messdaten (MD) umfasst die Schritte:
- Empfangen der Messdaten (MD), wobei die Messdaten (MD) eine inhomogene Dichte im k-Raum aufweisen,
- Anwenden wenigstens einer iterativen Rekonstruktionsfunktion (RkF) auf Eingangsdaten (ED), wobei die Eingangsdaten (ED) auf den empfangenen Messdaten (MD) basieren, und wobei Bilddaten (BD) umfassende Ausgangsdaten (AD) ermittelt werden, und wobei die Rekonstruktionsfunktion (RkF) mindestens eine Konsistenzprüfung umfasst, und wobei die iterative Rekonstruktionsfunktion (RkF) die Inhomogenität der Dichte der Messdaten (MD) im k-Raum im Rahmen zumindest einer von ihr umfassten Konsistenzprüfung homogenisiert,
- Bereitstellen der Ausgangsdaten (AD).

Durch ein erfindungsgemäßes Homogenisieren der Dichte im k-Raum der Messdaten (MD), auf welchen von der iterativen Rekonstruktionsfunktion (RkF) umfasste Konsistenzprüfungen basieren, wird die Inhomogenität im k-Raum der empfangenen Messdaten (MD) kompensiert, sodass ein Überbetonen von Messdaten mit einer höheren Dichte im k-Raum gegenüber von Messdaten mit einer geringeren Dichte im k-Raum vermieden wird. Dadurch werden Artefakte in den von den Ausgangsdaten (AD) umfassten Bilddaten (BD) vermieden oder zumindest reduziert.

## Beschreibung

Die Erfindung betrifft ein Verfahren zur iterativen Rekonstruktion von Bilddaten aus mittels einer Magnetresonanzanlage aufgenommenen Messdaten.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einem Magnetresonanzgerät in einem vergleichsweise starken statischen, homogenen Grundmagnetfeld, auch B₀-Feld genannt, mit Feldstärken von 0,2 Tesla bis 7 Tesla und mehr positioniert, so dass sich dessen Kernspins entlang des Grundmagnetfeldes orientieren. Zum Auslösen von als Signale messbaren Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder, kurz Gradienten genannt, überlagert. Ein verwendetes Schema, das eine zeitliche Abfolge von einzustrahlenden RF-Pulsen und zu schaltenden Gradienten beschreibt, wird als Pulssequenz(schema), oder auch kurz als Sequenz, bezeichnet. Die aufgezeichneten Messdaten werden digitalisiert und als komplexe Zahlenwerte in einer sogenannten k-Raum-Matrix im Frequenzraum abgelegt. Aus einer mit einer gemäß dem Nyquist-Theorem ausreichend dicht mit Werten belegten k-Raum-Matrix ist z.B. mittels einer mehrdimensionalen Fourier-Transformation ein zugehöriges MR-Bild rekonstruierbar.

Sogenannte parallele Akquisitionstechniken (ppa), wie z.B. GRAPPA ("GeneRalized Autocalibrating Partially Parallel Acquisition") oder SENSE ("Sensitivity Encoding"), bei denen mit Hilfe von mehreren RF-Spulen nur eine gemäß dem Nyquist-Theorem im k-Raum unterabgetastete Anzahl an Messdaten aufgenommen werden, können eingesetzt werden, um z.B. die für die Aufnahme der Messdaten insgesamt nötige Messzeit zu verkürzen oder die Auflösung zu erhöhen. Die "fehlenden", d.h. nicht gemessenen aber für einen gemäß Nyquist vollständigen Satz an Messdaten erforderlichen, Messdaten werden hierbei auf Basis von Sensitivitätsdaten der verwendeten RF-Spulen und Kalibrierungsdaten und den gemessenen Messdaten ergänzt.

Während bei ppa-Techniken der k-Raum gemäß einem regelmäßigen Abtastmuster, das z.B. nur jede f-te gemäß Nyquist zu messende k-Raumzeile abtastet, unterabgetastet wird, werden bei sogenannten Compressed-Sensing(CS)-Verfahren möglichst unregelmäßige, pseudo-zufällige Abtastmuster des k-Raums eingesetzt und die "fehlenden" Messdaten werden mittels iterativer Rekonstruktionsfunktionen unter Hinzunahme von a-priori Wissen, welche als Randbedingungen in das Optimierungsproblem der Rekonstruktionsfunktion eingehen, bestimmt. CS- und ppa-Techniken können auch kombiniert werden.

Seit einigen Jahren ist es weiterhin bekannt, trainierte Rekonstruktionsfunktionen, die auf sogenannten deep-learning(DL)-Algorithmen basierende neuronale Netze einzusetzen, um Bilddaten aus mittels Magnetresonanztechnik unterabgetastet aufgenommenen Messdaten zu rekonstruieren.

Ein Überblick über die Prinzipien von ppa, CS und zugehörige iterative Rekonstruktionsfunktionen bis hin zu trainierten Rekonstruktionsfunktionen ist in dem Artikel von Knoll et al., "Deep-Learning Methods for Parallel Magnetic Resonance Imaging Reconstruction: A Survey of the Current Approaches, Trends, and Issues", IEEE Signal Processing Mag. 37(1): S.128-140 (2020), gegeben.

In iterativen Rekonstruktionsfunktionen wird ein Optimierungsproblem in mehreren Iterationen, insbesondere im Rahmen von trainierten Rekonstruktionsfunktionen manchmal auch Kaskaden genannt, gelöst. Dabei umfassen zumindest einigen Iterationen eine Konsistenzprüfung (engl. "data consistency", DC), die über einen Vergleich von durch die Rekonstruktionsfunktion bestimmten Messdaten mit gemessenen Messdaten sicherstellt, dass die Rekonstruktionsfunktion konsistent mit der durchgeführten Messung ist. Neben den gemessenen Messdaten werden in der Regel auch Informationen über das bei der Aufnahme der Messdaten verwendete Abtastmuster und weitere, die Physik der Aufnahme beschreibende Informationen sowie die Sensitivitätsdaten der verwendeten RF-Spulen (in einem häufig mit **E** oder **A,** manchmal auch anders bezeichneten Operator) bei der Konsistenzprüfung berücksichtigt.

Eine trainierte Rekonstruktionsfunktion mit verschiedenen Arten an Iterationen, die z.B. einerseits nur Näherungsschritte (dort "pre-iterations" genannt) und andererseits Regularisierungsterme umfassen (dort "iterations" genannt), ist in der US20220114771A1 beschrieben. Die dort beschriebenen Iterationen umfassen jeweils eine Konsistenzprüfung (dort auch "gradient update" genannt). Es sind auch Iterationen denkbar, die lediglich eine Konsistenzprüfung umfassen. Bei trainierten Rekonstruktionsfunktionen oder iterativen CS-Rekonstruktionsfunktionen kann es sinnvoll sein, insbesondere im Anschluss an eine Reihe bereits erfolgter Iterationen, die Näherungsschritte und/oder Regularisierungsterme enthalten, zur weiteren Optimierung ein oder mehrere reine Konsistenzprüfungs-Iterationen durchzuführen.

Der Artikel von Hammernik et al., "Systematic evaluation of iterative deep neural networks for fast parallel MRI reconstruction with sensitivity-weighted coil combination", Magn Reson Med. 86: S.1859-1872 (2021) vergleicht verschiedene trainierte Rekonstruktionsfunktionen auch bezüglich ihrer Arten der Konsistenzprüfung.

Obwohl insbesondere mittels trainierten Rekonstruktionsfunktionen immer höhere Unterabtastungen und damit beschleunigte Messungen mit trotzdem grundsätzlich guter Bildqualität ermöglicht werden, können Artefakte, insbesondere sogenannte Banding Artefakte, die die diagnostische Qualität der so erstellten Bilddaten beeinträchtigen, auftreten wie es beispielsweise in dem Artikel von Dafazio et al., "MRI Banding Removal via Adversarial Training", 34th Conference on Neural Information Processing Systems (2020), arXiv:2001.08699, beschrieben werden, wo diese Artefakte durch Einsatz eines weiteren, adversen neuronalen Netzes bereinigt werden sollen.

Der Erfindung liegt die Aufgabe zugrunde, Artefakte in mittels iterativer Rekonstruktionsverfahren aus MR Messdaten rekonstruierten Bilddaten zu vermeiden, ohne zusätzliche neuronale Netze einsetzen zu müssen.

Der Erfindung liegt die Erkenntnis zugrunde, dass eine im k-Raum inhomogene Dichte von gemessenen Messdaten, auf Basis derer eine Konsistenzprüfung durchgeführt wird, im Rahmen der Konsistenzprüfung zu einer Überbetonung von bei der Aufnahme der Messdaten dichter abgetasteten Bereichen im k-Raum führt, welche Artefakte verursachen kann.

Die Aufgabe wird gelöst durch ein computerimplementiertes Verfahren zur Rekonstruktion von Bilddaten aus mittels einer Magnetresonanzanlage aufgenommenen Messdaten gemäß Anspruch 1, eine Rekonstruktionseinheit gemäß Anspruch 14, eine Magnetresonanzanlage gemäß Anspruch 15, ein Computerprogramm gemäß Anspruch 16, sowie ein computerlesbares Speichermedium gemäß Anspruch 17.

Ein erfindungsgemäßes computerimplementiertes Verfahren zur Rekonstruktion von Bilddaten aus mittels einer Magnetresonanzanlage aufgenommenen Messdaten umfasst die Schritte:
- Empfangen der Messdaten, wobei die Messdaten eine inhomogene Dichte im k-Raum aufweisen,
- Anwenden wenigstens einer iterativen Rekonstruktionsfunktion auf Eingangsdaten, wobei die Eingangsdaten auf den empfangenen Messdaten basieren, und wobei Bilddaten umfassende Ausgangsdaten ermittelt werden, und wobei die Rekonstruktionsfunktion mindestens eine Konsistenzprüfung umfasst, und wobei die iterative Rekonstruktionsfunktion die Inhomogenität der Dichte der Messdaten im k-Raum im Rahmen zumindest einer von ihr umfassten Konsistenzprüfung homogenisiert,
- Bereitstellen der Ausgangsdaten.

Durch ein erfindungsgemäßes Homogenisieren der Dichte im k-Raum der Messdaten, auf welchen von der iterativen Rekonstruktionsfunktion umfasste Konsistenzprüfungen basieren, wird die Inhomogenität im k-Raum der empfangenen Messdaten kompensiert, sodass ein Überbetonen von Messdaten mit einer höheren Dichte im k-Raum gegenüber von Messdaten mit einer geringeren Dichte im k-Raum vermieden wird. Dadurch werden Artefakte in den von den Ausgangsdaten umfassten Bilddaten vermieden oder zumindest reduziert.

Eine derartige Homogenisierung der Konsistenzprüfung(en) einer iterativen Rekonstruktionsfunktion kann mit nur geringem Aufwand durch Modifikation einer bereits bekannten iterativen Rekonstruktionsfunktionen in eine solche integriert werden.

Verschiedene Beispiele von Möglichkeiten einer derartigen Homogenisierung der Konsistenzprüfung(en) einer iterativen Rekonstruktionsfunktion werden im Folgenden beschrieben.

Eine erfindungsgemäße Rekonstruktionseinheit umfasst eine Recheneinheit und einen Speicher, und ist dazu ausgebildet ein hierin beschriebenes Verfahren auszuführen.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Kompensationsgradientenbestimmungseinheit.

Ein erfindungsgemäßes Computerprogramm implementiert ein erfindungsgemäßes Verfahren auf einer Steuereinrichtung, wenn es auf der Steuereinrichtung ausgeführt wird. Beispielsweise umfasst das Computerprogramm Befehle, die bei der Ausführung des Programms durch eine Steuereinrichtung, z.B. eine Steuereinrichtung einer Magnetresonanzanlage, diese Steuereinrichtung veranlassen, ein erfindungsgemäßes Verfahren auszuführen. Die Steuereinrichtung kann in Form eines Computers gestaltet sein.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in einer Recheneinheit des Rechensystems ausgeführt wird.

Ein erfindungsgemäßes computerlesbares Speichermedium umfasst Befehle, die bei der Ausführung durch eine Steuereinrichtung, z.B. eine Steuereinrichtung einer Magnetresonanzanlage, diese veranlassen, ein erfindungsgemäßes Verfahren auszuführen.

Das computerlesbare Speichermedium kann als elektronisch lesbarer Datenträger ausgestaltet sein, welcher darauf gespeicherte elektronisch lesbare Steuerinformationen umfasst, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:
Fig. 1 ein schematisches Ablaufdiagram eines erfindungsgemäßen Verfahrens,
Figs. 2-6 schematisch dargestellte Beispiele von Messdaten im k-Raum auf Basis derer erfindungsgemäße Konsistenzprüfung durchgeführt werden können,
Fig. 7 eine erfindungsgemäße Rekonstruktionseinheit,
Fig. 8 eine schematisch dargestellte erfindungsgemäße Magnetresonanzanlage.

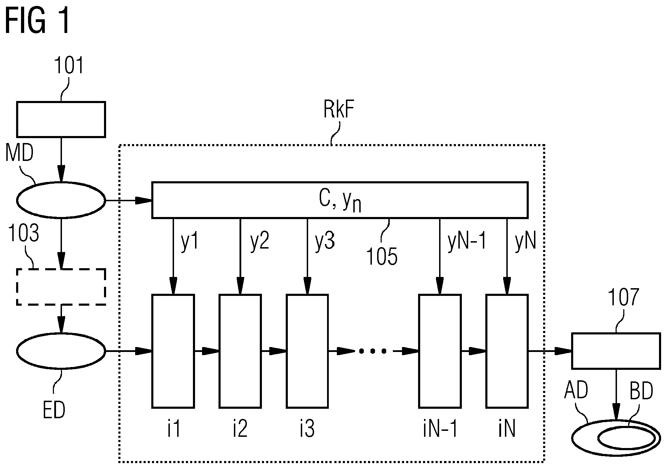

Figur 1 ist ein schematisches Ablaufdiagramm eines erfindungsgemäßen computerimplementierten Verfahrens zur Rekonstruktion von Bilddaten BD aus mittels einer Magnetresonanzanlage aufgenommenen Messdaten MD.

Es werden Messdaten MD empfangen, die eine inhomogene Dichte im k-Raum aufweisen, d.h. die empfangenen Messdaten haben in mindestens einem ersten Bereich des k-Raums eine andere Dichte als in mindestens einem von dem ersten Bereich verschiedenen zweiten Bereich des k-Raums. Die Messdaten MD wurden mittels einer Magnetresonanzanlage mit einem die Dichte im k-Raum festlegenden Abtastmuster aufgenommen (Block 101). Beispielsweise können die Messdaten MD gemäß einem ppa-Verfahren oder einem CS-Verfahren aufgenommen worden sein.

Die Messdaten MD, auf Basis derer die Eingangsdaten ED erstellt wurden, können in einem in zumindest einer k-Raumrichtung zentralen Bereich im k-Raum eine höhere Dichte aufweisen als in dem restlichen, peripheren Bereich des k-Raums.

Die empfangenen Messdaten können dabei z.B. gemäß einem Abtastmuster von entlang von in Ausleserichtung kx verlaufenden, parallelen k-Raumzeilen, die in Phasenkodierrichtung ky beabstandet sind, aufgenommen worden sein.

Die empfangenen Messdaten MD können auch Referenzdaten umfassen auf Basis derer Spulensensitivitätsdaten C von bei der Aufnahme der empfangenen Messdaten MD verwendeten Spulen ermittelt werden.

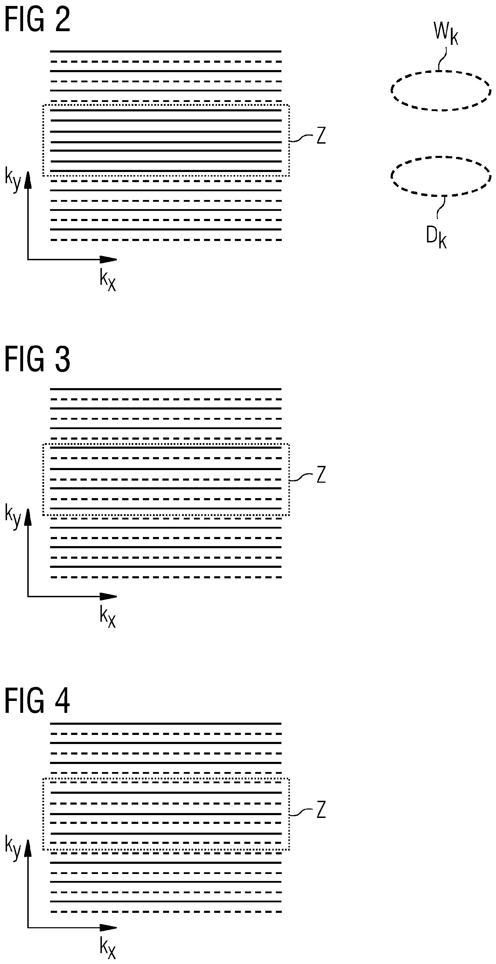

In dem in Figur 2 dargestellte Beispiel von Messdaten im k-Raum sind entlang von k-Raumzeilen gemessene Messdaten als durchgehende Linien dargestellt. Die gestrichelt dargestellten Linien entsprechen k-Raumzeilen, die zwar gemäß dem Theorem von Nyquist für eine vollständige Abtastung des k-Raums aufgenommen werden müssten, die aber tatsächlich nicht aufgenommen wurden. In dem dargestellten Beispiel wurde in einem in Phasenkodierrichtung zentralen Bereich Z der k-Raum vollständig abgetastet, in den in Phasenkodierrichtung peripheren Bereichen wurde jedoch nur jede zweite k-Raumzeile aufgenommen. Mit einem derartigen Abtastschema im k-Raum aufgenommene Messdaten könnten beispielsweise im Rahmen eines ppa-Verfahrens mit Beschleunigungsfaktor Zwei (R=2) und, durch die vollständige Abtastung des zentralen Bereichs Z des k-Raums, mit integrierter Aufnahme von Referenzdaten, aus welchen z.B. Spulensensitivitätsdaten C ermittelt werden können, aufgenommen worden sein. Spulensensitivitätsdaten C können alternativ auch aus in einer separaten Aufnahme aufgenommenen Referenzdaten ermittelt werden.

Die Messdaten MD können für ein erfindungsgemäßes Verfahren analog auch gemäß anderen bekannten Abtastschemata aufgenommen worden sein. Die Beispiele der Figuren 2 bis 6 dienen lediglich der Veranschaulichung des erfindungsgemäßen Konzepts und sind nicht einschränkend zu lesen.

Auf Eingangsdaten ED, die auf den empfangenen Messdaten MD basieren, wird wenigstens eine iterative Rekonstruktionsfunktion RkF angewandt, wobei Bilddaten BD umfassende Ausgangsdaten AD ermittelt werden. Die Eingangsdaten ED können hierbei empfangene Messdaten MD umfassen und ggf. (zusätzlich) auch aus den empfangenen Messdaten MD rekonstruierte erste Bilddaten (nicht dargestellt) sein (Block 103).

Die iterative Rekonstruktionsfunktion RkF umfasst mehrere, mindestens zwei, Iterationen i1, i2, ..., iN (N≥2), und die iterative Rekonstruktionsfunktion RkF umfasst mindestens eine Konsistenzprüfung. Insbesondere kann jede Iteration der iterativen Rekonstruktionsfunktion RkF eine Konsistenzprüfung umfassen. Auf diese Weise wird eine Konsistenz aller Iterationsergebnisse mit den physikalischen Bedingungen, unter welchen die empfangenen Messdaten MD aufgenommen wurden, und somit eine Konsistenz mit den Messdaten MD, sichergestellt.

Die iterative Rekonstruktionsfunktion RkF kann beispielsweise eine trainierte Rekonstruktionsfunktion oder eine Rekonstruktionsfunktion eines Compressed-Sensing-Verfahrens sein, wie sie z.B. in den oben genannten Artikel von Knoll et al. und Hammernik et al. oder auch der US20220114771A1 beschrieben sind. Insbesondere kann die iterative Rekonstruktionsfunktion RkF eine Reihe an sogenannten pre-iterationen, eine Reihe von Iterationen mit Regularisierungstermen und/oder eine Reihe von reinen Konsistenzprüfungs-Iterationen umfassen.

Weiter homogenisiert die iterative Rekonstruktionsfunktion RkF im Rahmen zumindest einer von ihr umfassten Konsistenzprüfung die Inhomogenität der Dichte der empfangenen Messdaten im k-Raum. Dazu können homogenisierte Messdaten yn (n = 1, ..., N) ermittelt werden auf Basis derer jeweilige Konsistenzprüfungen durchgeführt werden (Block 105).

Ein derartiges Homogenisieren der Dichte der Messdaten, auf welchen von der iterativen Rekonstruktionsfunktion RkF umfasste Konsistenzprüfungen basieren, führt zu einer Kompensation der Inhomogenität der Dichte im k-Raum der empfangenen Messdaten. Dadurch wird ein Überbetonen von Messdaten mit einer höheren Dichte im k-Raum gegenüber von Messdaten mit einer geringeren Dichte im k-Raum entweder insgesamt oder bereits in den Zwischenergebnissen ("Updates") der Iterationen mit Konsistenzprüfung vermieden, wodurch die Bildqualität von durch die iterative Rekonstruktionsfunktion RkF rekonstruierten Bilddaten erhöht wird.

Dabei können alle empfangenen Messdaten MD zumindest in einer von der iterativen Rekonstruktionsfunktion RkF umfassten Konsistenzprüfung berücksichtigt werden, sodass keine der empfangenen Messdaten nicht Teil zumindest eines Satzes von homogenisierten Messdaten yn ist, der Basis zumindest einer Konsistenzprüfung ist. Auf diese Weise werden alle vorhandenen (da empfangenen) gemessenen Messdaten in zumindest einer Konsistenzprüfung verwendet, wodurch ein erreichbares Signalzu-Rausch-Verhältnis erhalten bleibt, da keine gemessenen Messdaten nicht berücksichtigt werden.

Konsistenzprüfungen können zusätzlich auf Basis von in den empfangenen Messdaten umfassten Referenzdaten ermittelten Spulensensitivitätsdaten C durchgeführt werden, die dafür auf bekannte Weise in den entsprechenden Operator der Konsistenzprüfung einbezogen werden. Es kann sein, dass durch die oben beschriebene Homogenisierung der Dichte der empfangenen Messdaten im Rahmen einer Konsistenzprüfung von den empfangenen Messdaten umfasste Referenzdaten nicht als Messdaten yn der Konsistenzprüfung berücksichtigt werden. Auch in einem solchen Fall können die Referenzdaten jedoch indirekt über die aus ihnen ermittelten Spulensensitivitätsdaten C in der Konsistenzprüfung berücksichtigt werden.

Eine Homogenisierung der Dichte der Messdaten im Rahmen der Konsistenzprüfungen kann erreicht werden, indem zumindest zwei von der iterativen Rekonstruktionsfunktion RkF umfasste Konsistenzprüfungen auf Basis von sich unterscheidenden Teilmengen der empfangenen Messdaten durchgeführt werden. Ein in einer Konsistenzprüfung einer Iteration, z.B. i1, in der iterativen Rekonstruktionsfunktion RkF verwendeter Satz von homogenisierten Messdaten, z.B. y1, entspricht hierbei einer der Teilmengen. In den Iterationen i1, ..., iN der iterativen Rekonstruktionsfunktion RfK können z.B. alle Teilmengen abwechselnd als jeweiliger Satz von homogenisierten Messdaten yn (n = 1 ... N) verwendet werden, sodass z.B. bei zwei verschiedenen Teilmengen alle yn mit geradem n der einen Teilmenge entsprechen und alle yn mit ungeradem n der anderen Teilmenge.

Dabei können die Teilmengen derart gewählt werden, dass jede Teilmenge eine höhere Homogenität der Dichte der jeweils enthaltenen Messdaten im k-Raum als die empfangenen Messdaten aufweist, oder zumindest in den Teilmengen enthaltene Messdaten über die in Konsistenzprüfungen eingesetzten Teilmengen gemittelt eine höhere Homogenität in ihrer Dichte aufweisen.

Zumindest eine von der iterativen Rekonstruktionsfunktion RkF umfasste Konsistenzprüfung kann auf Basis einer homogenisierten Teilmenge der empfangenen Messdaten durchgeführt werden, die durch Entfernen von Messdaten der empfangenen Messdaten eine zumindest in Abschnitten jeweils gleiche homogene Dichte im k-Raum, insbesondere eine im gesamten k-Raum homogene Dichte aufweist.

Eine Homogenisierung der Dichte der Messdaten im Rahmen der Konsistenzprüfungen kann bereits erreicht werden, wenn zumindest eine von der iterativen Rekonstruktionsfunktion RkF umfasste Konsistenzprüfung auf Basis einer homogenisierten Teilmenge der empfangenen Messdaten durchgeführt wird. Somit kann zumindest eine von der iterativen Rekonstruktionsfunktion RkF umfasste Konsistenzprüfung auf Basis der empfangenen Messdaten durchgeführt werden, sodass dort bereits alle empfangenen Messdaten Berücksichtigung finden, was das Signalzu-Rausch-Verhältnis bereits aufrechterhält, sodass eine einzige homogenisierte Teilmenge für andere Konsistenzprüfungen der iterativen Rekonstruktionsfunktion RkF bereits zu einer gewünschten Homogenisierung führt. Für eine bessere Homogenisierung werden jedoch allenfalls in einigen Iterationen, beispielsweise alle x Iterationen (mit x zwischen 2 und N, je nach gewünschtem Grad an Homogenisierung) die jeweiligen Konsistenzprüfungen auf Basis der empfangenen Messdaten durchgeführt.

Ausgehend von dem in Figur 2 gezeigten Beispiel von Messdaten im k-Raum, zeigen die Figuren 3 und 4 Beispiele für eine Homogenisierung der Dichte der Messdaten im Rahmen der Konsistenzprüfungen durch Entfernen von Messdaten von den empfangenen Messdaten. In den Figuren 3 und 4 wurden, ausgehend von den in Figur 2 dargestellten Messdaten als Beispiel von empfangenen Messdaten, derart Messdaten entfernt, dass, im Fall von Figur 3 im gesamten k-Raum eine homogene Dichte an Messdaten verbleibt, hier eine Dichte, die jeder zweiten gemäß Nyquist aufzunehmenden k-Raumzeile entspricht; und dass, im Fall von Figur 4 in Abschnitten, die dem zentralen Bereich des k-Raums Z und den jeweiligen peripheren Bereichen entsprechen, jeweils ebenfalls eine homogene Dichte verbleibt, die jeder zweiten gemäß Nyquist aufzunehmenden k-Raumzeile entspricht.

Bei ppa-Verfahren mit integrierter Aufnahme von Referenzdaten, also vollständig aufgenommenem zentralen Bereich Z des k-Raums, und größeren Beschleunigungsfaktoren, z.B. R=4, in den peripheren Bereichen könnten beispielsweise vier Teilmengen gebildet werden, in welchen derart Messdaten entfernt wurden, dass im zentralen Bereich Z des k-Raums ebenfalls jeweils eine Dichte verbleibt, welche jeder vierten gemäß Nyquist aufzunehmenden k-Raumzeile entspricht.

Bei CS-Verfahren können derart Messdaten entfernt werden, dass analog in Abschnitten jeweils eine Dichte, die z.B. einer Anzahl an k-Raumzeilen bzw. k-Raumpunkten pro gemäß Nyquist aufzunehmender k-Raumzeilen bzw. k-Raumpunkten entspricht, erreicht wird.

Allgemein können die Messdaten derart entfernt werden, dass eine Dichte in dem zentralen Bereich Z im k-Raum, der in den empfangenen Messdaten eine höhere Dichte an Messdaten als die peripheren Bereiche aufweist, einer (geringeren) Dichte des restlichen, peripheren Bereichs des k-Raums angepasst wird.

Es ist auch denkbar, dass Messdaten zufällig entfernt werden, sodass von der iterativen Rekonstruktionsfunktion RkF umfasste Konsistenzprüfungen auf Basis von, insbesondere unterschiedlichen, randomisierten Teilmengen der empfangenen Messdaten durchgeführt werden. Hierbei kann als Randbedingung für das Entfernen z.B. eine Mindestanzahl an Messdaten, die nach dem Entfernen in der randomisierten Teilmenge verbleiben müssen, angegeben werden. Dabei können aus dem gesamten k-Raum Messdaten zufällig entfernt werden, oder, als (weitere) Randbedingung, aus Bereichen des k-Raums, die eine höherer Dichte an Messdaten aufweisen als andere Bereiche des k-Raums.

Bei Verwendung einer trainierten Rekonstruktionsfunktion als iterativer Rekonstruktionsfunktion RkF kann ein derartiges zufälliges Entfernen von empfangenen Messdaten bereits im Training der trainierten Rekonstruktionsfunktion mit Bezug auf die empfangenen Trainingsdaten eingesetzt werden. Auf diese Weise kann ein Satz an Trainingsdaten mehrfach verwendet werden, was die Datenbasis verbessert.

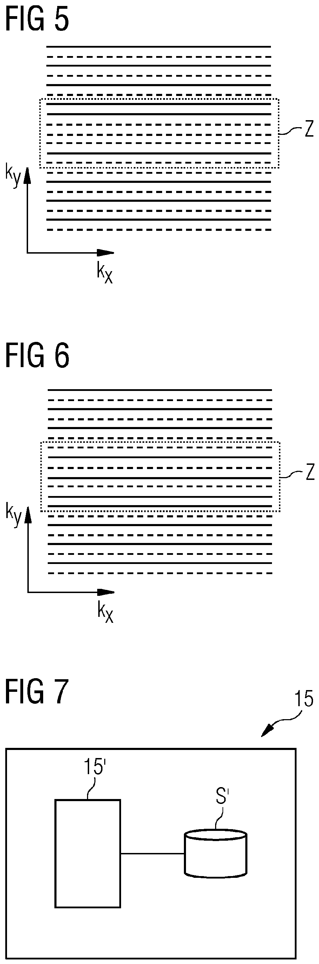

Ausgehend von dem in Figur 2 gezeigten Beispiel von Messdaten im k-Raum, zeigen die Figuren 5 und 6 Beispiele für eine Homogenisierung der Dichte der Messdaten im Rahmen der Konsistenzprüfungen durch zufälliges Entfernen von Messdaten von den empfangenen Messdaten. In den gezeigten Beispielen wurden in dem zentralen Bereich Z derart Messdaten entfernt, dass jeweils eine Dichte verbleibt, die im Mittel möglichst nahe an der Dichte an Messdaten in den peripheren Bereichen liegt.

Eine Homogenisierung der Dichte der Messdaten im Rahmen der Konsistenzprüfungen kann auch erreicht werden, indem zumindest eine von der iterativen Rekonstruktionsfunktion RkF umfasste Konsistenzprüfung auf Basis der einer Wichtung Wₖ unterzogenen empfangenen Messdaten durchgeführt wird, wobei die Wichtung Wₖ die inhomogene Dichte im k-Raum ausgleicht. Am Beispiel der in Figur 2 dargestellten Messdaten im k-Raum kann eine derartige Wichtung Wₖ derart gestaltet sein, dass sie die Messdaten gemäß des Inversen der ihrer Position k im k-Raum entsprechenden Dichte gewichtet. Es ist denkbar alle von der iterativen Rekonstruktionsfunktion RkF umfasste Konsistenzprüfungen auf Basis der derartig gewichteten empfangenen Messdaten durchzuführen. Auf diese Weise kann für die Konsistenzprüfungen jeweils derselbe Operator verwendet werden, was nur eine besonders geringe Modifikation von bekannten Konsistenzprüfungen erfordert.

Eine Homogenisierung der Dichte der Messdaten im Rahmen der Konsistenzprüfungen kann auch erreicht werden, indem zumindest eine von der iterativen Rekonstruktionsfunktion RkF umfasste Konsistenzprüfung auf Basis der empfangenen Messdaten durchgeführt wird, und durch ein Prekonditionierungsverfahren die Beiträge der empfangenen Messdaten verschiedener k-Raumbereiche derart modifiziert werden, dass alle k-Raumbereiche homogen beitragen. Ein derartiges Prekonditionierungsverfahren ist beispielsweise aus dem Artikel von Ong et al., "Accelerating Non-Cartesian MRI Reconstruction Convergence using k-space Preconditioning", IEEE Trans Med Imaging 39: S. 1646-1654 (2020), bekannt. Hierbei kann im Rahmen der Konsistenzprüfungen zunächst auf bekannte Weise der übliche Konsistenz-Gradient bestimmt werden, bevor dieser mittels Dichtekompensierungsfaktoren Dₖ des Prekonditionierungsverfahrens homogenisiert wird. Auch hier kann für die Konsistenzprüfungen jeweils derselbe Operator verwendet werden, bevor die Beiträge der verschiedenen k-Raumbereiche angeglichen werden. Auch hier ist nur eine besonders geringe Modifikation von bekannten Konsistenzprüfungen erforderlich.

Die vorgestellten Möglichkeiten eine Homogenisierung der Dichte der Messdaten im Rahmen durchgeführter Konsistenzprüfungen zu erreichen können kombiniert werden.

Die Ausgangsdaten AD werden bereitgestellt (Block 107) und können z.B. gespeichert, angezeigt oder weiterverarbeitet werden. Die von den Ausgangsdaten AD umfassten Bilddaten BD wurden so aus den empfangenen Messdaten MD rekonstruiert und sind durch die beschriebene gegenüber bekannten Verfahren homogenisierte Konsistenzprüfung von Artefakten befreit.

Figur 7 stellt schematische eine erfindungsgemäße Rekonstruktionseinheit 15 dar. Die Rekonstruktionseinheit 15 umfasst eine Recheneinheit 15' zum Durchführen von Rechenschritten für ein hierin beschriebenes Verfahren, welche Daten empfangen und senden kann. Zum Speichern von Daten, Zwischenergebnissen und/oder Ergebnissen umfasst die Rekonstruktionseinheit 15 weiterhin einen Speicher S'. Die Darstellung ist rein schematisch. Die Rekonstruktionseinheit 15 kann auch in einer Rechenstruktur ggf. mit verschiedenen Recheneinheiten, Schnittstellen und/oder Speichern integriert sein oder auf vorhandene Recheneinheiten und/oder Speicher zurückgreifen.

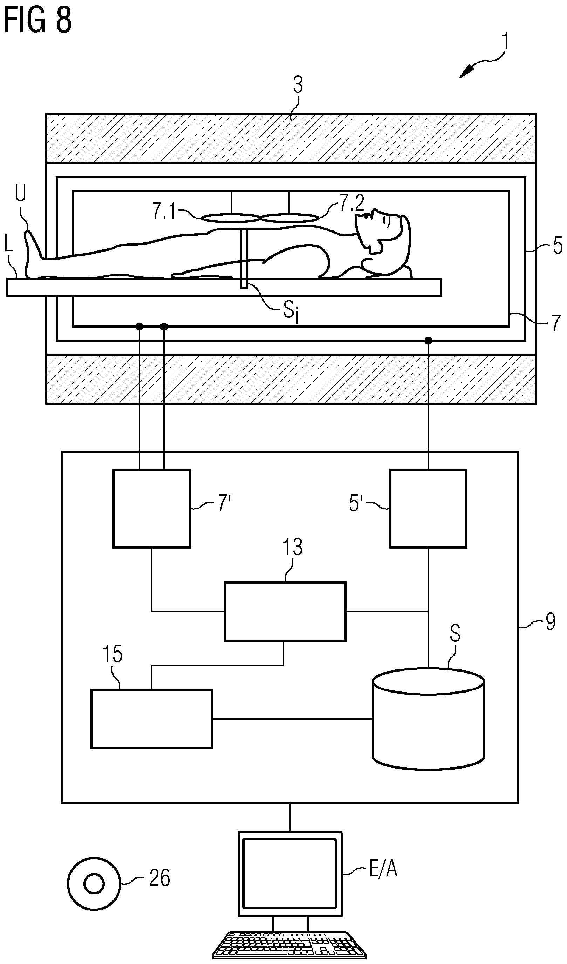

Figur 8 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9.

In der Figur 8 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schicht oder der Slab Sᵢ stellt ein exemplarisches Zielvolumen des Untersuchungsobjekts dar, aus dem Echosignale aufgenommen und als Messdaten erfasst werden sollen.

Die Steuereinrichtung 9 dient der Steuerung der Magnetresonanzanlage 1 und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7' für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei wird die Mittenfrequenz des, auch als B1-Feld bezeichneten, Hochfrequenz-Wechselfeldes in aller Regel möglichst so eingestellt, dass sie nahe der Resonanzfrequenz der zu manipulierenden Spins liegt. Abweichungen von der Mittenfrequenz von der Resonanzfrequenz werden als Off-Resonanz bezeichnet. Zur Erzeugung des B1-Feldes werden in der Hochfrequenzeinheit 7 mittels der Hochfrequenz-Sende-/Empfangs-Steuerung 7' gesteuerte Ströme an den HF-Spulen angelegt.

Weiterhin umfasst die Steuereinrichtung 9 eine Rekonstruktionseinheit 15, mit welcher eine erfindungsgemäße Rekonstruktion von Bilddaten ausgeführt werden kann. Die Steuereinrichtung 9 ist insgesamt dazu ausgebildet, ein erfindungsgemäßes Verfahren durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogramms vorliegen, welches Befehle umfasst, die das beschriebene Verfahren auf einer Steuereinrichtung 9 ausführen. Ebenso kann ein computerlesbares Speichermedium vorliegen, welches Befehle umfasst, die bei der Ausführung durch eine Steuereinrichtung 9 einer Magnetresonanzanlage 1 diese veranlassen, das beschriebene Verfahren auszuführen.

## Patentansprüche

1. Computerimplementiertes Verfahren zur Rekonstruktion von Bilddaten (BD) aus mittels einer Magnetresonanzanlage (1) aufgenommenen Messdaten (MD), umfassend die Schritte:
- Empfangen der Messdaten (MD), wobei die Messdaten (MD) eine inhomogene Dichte im k-Raum aufweisen,
- Anwenden wenigstens einer iterativen Rekonstruktionsfunktion (RkF) auf Eingangsdaten (ED), wobei die Eingangsdaten (ED) auf den empfangenen Messdaten (MD) basieren, und wobei Bilddaten (BD) umfassende Ausgangsdaten (AD) ermittelt werden, und wobei die Rekonstruktionsfunktion (RkF) mindestens eine Konsistenzprüfung umfasst, und wobei die iterative Rekonstruktionsfunktion (RkF) die Inhomogenität der Dichte der Messdaten (MD) im k-Raum im Rahmen zumindest einer von ihr umfassten Konsistenzprüfung homogenisiert,
- Bereitstellen der Ausgangsdaten (AD).

2. Verfahren nach Anspruch 1, wobei die iterative Rekonstruktionsfunktion (RkF) eine trainierte Rekonstruktionsfunktion oder eine Rekonstruktionsfunktion eines Compressed-Sensing-Verfahrens ist.

3. Verfahren nach einem der vorhergehenden Ansprüche, wobei die Messdaten (MD), auf Basis derer die Eingangsdaten (ED) erstellt wurden, in einem in zumindest einer k-Raumrichtung zentralen Bereich (Z) im k-Raum eine höhere Dichte aufweisen als in dem restlichen, peripheren Bereich des k-Raums.

4. Verfahren nach einem der vorhergehenden Ansprüche, wobei die empfangenen Messdaten (MD) Referenzdaten umfassen auf Basis derer Spulensensitivitätsdaten (C) von bei der Aufnahme der empfangenen Messdaten (MD) verwendeten Spulen ermittelt werden.

5. Verfahren nach Anspruch 4, wobei Konsistenzprüfungen auf Basis der aus den Referenzdaten ermittelten Spulensensitivitätsdaten (C) durchgeführt werden.

6. Verfahren nach einem der vorhergehenden Ansprüche, wobei alle empfangenen Messdaten (MD) zumindest in einer von der iterativen Rekonstruktionsfunktion (RkF) umfassten Konsistenzprüfung berücksichtigt werden.

7. Verfahren nach einem der vorhergehenden Ansprüche, wobei jede Iteration der iterativen Rekonstruktionsfunktion (RkF) eine Konsistenzprüfung umfasst.

8. Verfahren nach einem der vorhergehenden Ansprüche, wobei zumindest zwei von der iterativen Rekonstruktionsfunktion (RkF) umfasste Konsistenzprüfungen auf Basis von sich unterscheidenden Teilmengen der empfangenen Messdaten (MD) durchgeführt werden.

9. Verfahren nach einem der vorhergehenden Ansprüche, wobei zumindest eine von der iterativen Rekonstruktionsfunktion (RkF) umfasste Konsistenzprüfung auf Basis einer homogenisierten Teilmenge der empfangenen Messdaten (MD) durchgeführt wird, die durch Entfernen von Messdaten der empfangenen Messdaten (MD) eine zumindest in Abschnitten jeweils gleiche homogene Dichte im k-Raum, insbesondere eine im gesamten k-Raum homogene Dichte aufweist.

10. Verfahren nach Anspruch 9, wobei die Messdaten derart entfernt werden, dass eine Dichte in dem zentralen Bereich (Z) im k-Raum der Dichte des restlichen, peripheren Bereichs des k-Raums angepasst wird.

11. Verfahren nach einem der vorhergehenden Ansprüche, wobei von der iterativen Rekonstruktionsfunktion (RkF) umfasste Konsistenzprüfungen auf Basis von randomisierten Teilmengen der empfangenen Messdaten (MD) durchgeführt werden.

12. Verfahren nach einem der vorhergehenden Ansprüche, wobei zumindest eine von der iterativen Rekonstruktionsfunktion (RkF) umfasste Konsistenzprüfung auf Basis der einer Wichtung unterzogenen empfangenen Messdaten (MD) durchgeführt wird, wobei die Wichtung die inhomogene Dichte im k-Raum ausgleicht.

13. Verfahren nach einem der vorhergehenden Ansprüche, wobei zumindest eine von der iterativen Rekonstruktionsfunktion (RkF) umfasste Konsistenzprüfung auf Basis der empfangenen Messdaten (MD) durchgeführt wird, und durch ein Prekonditionierungsverfahren die Beiträge der empfangenen Messdaten (MD) verschiedener k-Raumbereiche derart modifiziert werden, dass alle k-Raumbereiche homogen beitragen.

14. Rekonstruktionseinheit (15) umfassend eine Recheneinheit (15') und einen Speicher (S'), dazu ausgebildet ein Verfahren nach einem der Ansprüche 1 bis 13 auszuführen.

15. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und mit einer Rekonstruktionseinheit nach Anspruch 14.

16. Computerprogramm, umfassend Befehle, die bei der Ausführung des Programms durch einen Computer diesen veranlassen, das Verfahren nach einem der Ansprüche 1 bis 13 auszuführen.

17. Computerlesbares Speichermedium, umfassend Befehle, die bei der Ausführung durch einen Computer diesen veranlassen, das Verfahren nach einem der Ansprüche 1 bis 13 auszuführen.
